# EUROPEAN PATENT APPLICATION

(11) **EP 4 848 588 A1**
(43) Date of publication of application: **02.12.2026**
(21) Application number: 26179360.8
(22) Date of filing: 18.05.2026
(51) Int. Cl.: H03K 5/135, H03K 3/037

(54) **ALL-DIGITAL PHASE SYNCHRONIZER FOR MULTI-MODULE SYSTEMS**

(30) Priority: 29.05.2025 US 202519221705
(71) Applicant: STMicroelectronics International N.V., 1228 Plan-les-Ouates, Geneva (CH)
(72) Inventor: BAL, Ankur, 201308 Greater Noida (IN); GUPTA, Sharad, 110059 New Delhi (IN)
(74) Representative: Casalonga

(57) **Abstract**

A multi-channel synchronization system achieves phase alignment across multiple devices through a propagated reset mechanism. The system utilizes a chain of devices (21a-21c), where the first device (21a) receives an asynchronous reset signal (RSTN_IN), synchronizes it to the system clock domain using untimed reset removal, and introduces a controlled delay before generating a synchronized reset signal (RSTN_OUT1). A subsequent device (21b) receives this synchronized signal, processes it using timed reset removal to eliminate metastability concerns, and adds its own controlled delay before propagating to the next device (21c). The architecture confines timing uncertainty to only the first device while ensuring deterministic timing for all subsequent devices. This approach avoids system-wide high-speed signal distribution and clock gating, making it suitable for applications requiring precise phase alignment such as analog-to-digital converters, serial interfaces, and digital signal processors. The system is scalable to any number of devices while maintaining proper phase synchronization.

## Description

### TECHNICAL FIELD

This disclosure relates to synchronization mechanisms in multi-channel systems and, more particularly, to phase alignment between multiple devices such as analog-to-digital converters (ADCs).

### BACKGROUND

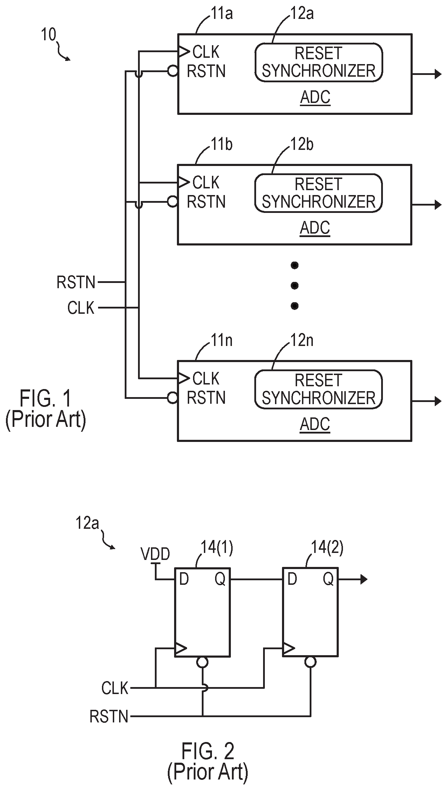

In a multi-channel radio frequency (RF) system 10, such as that shown in FIG. 1, maintaining phase synchronization between multiple Analog-to-Digital Converters (ADCs) 11a, ..., 11n is of concern. These ADCs 11a, ..., 11n have interconnected data paths that must maintain synchronized timing for a variety of applications. The ADCs 11a, ..., 11n must operate "in-phase," meaning that all ADCs 11a, ..., 11n sample their inputs on the same clock edges and provide their outputs on the same clock edges, ensuring that the Nth sample taken by each ADC 11a, ..., 11n corresponds to the same moment in time within a tolerance of ±Δϕ (where Δϕ ≤ one CLK period). While the discussion focuses on ADCs, the challenges and solutions described herein are equally applicable to other multi-module systems, such as serial links, digital signal processors (DSPs), and computational blocks.

A primary challenge of achieving this synchronized timing in such systems is managing the reset removal process in a way that ensures all ADCs exit reset simultaneously. When ADCs experience different reset removal timing, some might wake up one clock cycle before others, creating a phase misalignment that breaks the required synchronization. Additionally, achieving local synchronization between neighboring blocks is critical for ensuring robust operation, as it minimizes the impact of timing uncertainties and external disruptions.

In order to facilitate synchronized timing, a system-wide asynchronous reset signal RSTN is used to simultaneously reset all ADCs 11a, ..., 11n, ensuring they all begin operation at the same time. RSTN is defined as an active-low reset signal: assertion occurs when RSTN transitions from logic high to logic low on the falling edge, and deassertion occurs when RSTN returns high on the rising edge. While RSTN remains low, all internal flip-flops, registers, and state machines within each ADC are forced into a predetermined reset state (e.g., outputs cleared, bias circuits held in reset, digital filter states zeroed, etc).

Each ADC 11a, ..., 11n includes a respective internal reset synchronizer 12a, ..., 12n to safely transition the asynchronous reset signal RSTN into the synchronous clock domain of CLK. Without such synchronizers, an asynchronous reset signal RSTN could be captured at different times by different circuit elements within the ADC, leading to inconsistent internal state initialization. As shown in FIG. 2, each reset synchronizer 12a, ..., 12n comprises two D-type flip-flops 14(1) and 14(2) in series with the D input of the first flip-flop 14(1) tied to logic '1' (VDD). Under normal operation, when RSTN transitions from low to high (is deasserted) well before a rising edge of CLK, the first flip-flop 14(1) captures logic '1' on the immediately following rising edge of CLK, and the second flip-flop 14(2) captures that logic '1' on the subsequent rising edge of CLK, thereby producing a fully synchronous reset release after precisely two rising clock edges.

However, the reset synchronizers 12a, ..., 12n themselves are potentially susceptible to metastability. This creates a fundamental issue where some ADCs might recover from reset in two clock cycles while others take three clock cycles, leading to the one-cycle phase error between ADCs. This occurs when the RSTN deassertion (low-to-high transition) happens too close to a rising edge of CLK. Specifically, for proper operation, the deassertion of RSTN must be properly timed with respect to the next rising edge of CLK to satisfy the specified removal time (t_REM) requirements and recovery time (t_REC) requirements; yet, since RSTN is asynchronous, this will not always be the case. The removal time t_REM is the minimum interval between the last rising edge of CLK and the falling edge of RSTN (assertion) to avoid a removal time violation; a removal time violation occurs when this interval is too short, potentially causing some flip-flops to miss the reset assertion. The recovery time t_REC is the minimum interval between the rising edge of RSTN (deassertion) and the next rising edge of CLK to avoid a recovery time violation; a recovery time violation occurs when this interval is too short. When a recovery time violation occurs (when RSTN transitions from low to high too close to a rising clock edge), the output of flip-flop 14(1) can enter an unstable metastable state between valid logic levels '0' and '1', taking an unpredictable amount of time to resolve to either state. In this metastable scenario, if the output of flip-flop 14(1) remains metastable beyond the setup time of flip-flop 14(2) for the next rising edge of CLK, then flip-flop 14(2) will not capture the correct value on that rising edge. The setup time is the minimum amount of time before a clock edge that an input signal must be stable for the flip-flop to reliably capture that input. Instead, flip-flop 14(1) will resolve to logic '1' after that rising edge has passed, and flip-flop 14(2) will only capture this value on the subsequent rising edge of CLK-the third rising edge after RSTN deassertion. This results in reset propagation taking three rising clock edges rather than the expected two rising clock edges to complete. When some ADCs propagate reset in two rising clock edges while others take three rising clock edges, they exit reset exactly one clock cycle apart from each other, creating what is known as one-cycle phase error, which breaks synchronization.

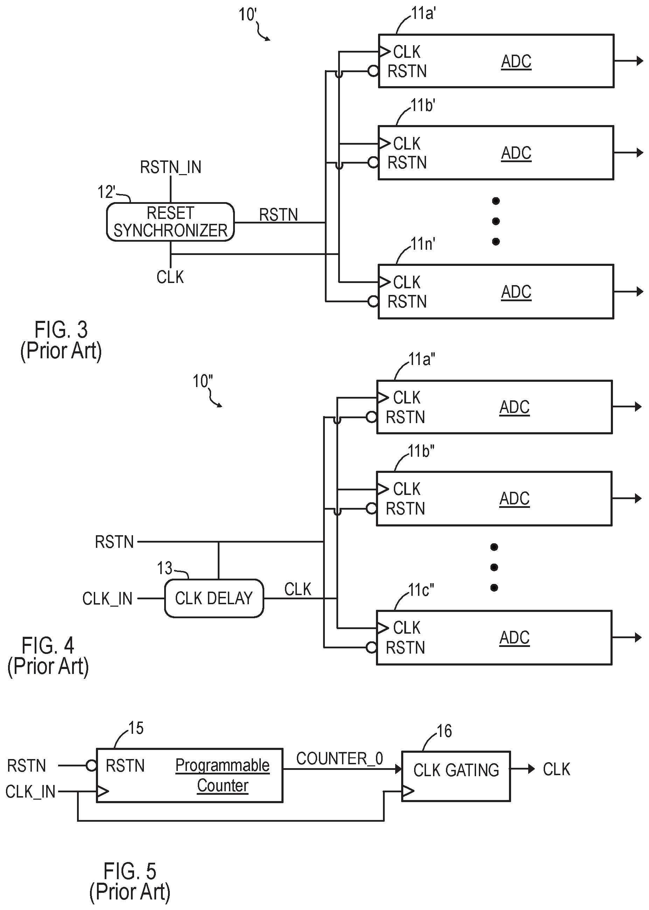

Attempts at solving this problem have been made. In multi-channel system 10' shown in FIG. 3, one approach to reduce metastability uncertainty is to use a single reset synchronizer 12' shared by all ADCs 11a', ..., 11n' rather than having separate reset synchronizers in each ADC. The reset synchronizer 12' receives an incoming asynchronous reset signal RESET_IN and generates the synchronized RSTN used to reset all ADCs 11a', ..., 11n' in parallel. By using one shared reset synchronizer 12', the metastability uncertainty is confined to that one block. However, this approach creates a new problem: the synchronized RSTN signal must now be distributed to multiple ADCs across physical PCB traces at gigahertz speeds. These long routing distances introduce significant timing skew (t_skew) due to trace length mismatches, impedance variations, and parasitic capacitances. At gigahertz frequencies, even small differences in trace lengths cause the reset signal to arrive at different ADCs at different times, making it extremely difficult to maintain proper phase relationships. Additionally, routing high-speed signals over longer distances is power-intensive.

Another approach implemented in multi-channel system 10" shown in FIG. 4 uses a clock delay circuit 13 that holds the clock signal until all ADCs have completed their reset sequences. This approach attempts to solve the issue by ensuring all ADCs start receiving clock signals simultaneously, regardless of when they individually exit their reset states. As shown in FIG. 5, the clock delay circuit 13 comprises a programmable counter 15 and a clock-gating cell 16. This circuit operates as follows: when RSTN transitions from low to high (is deasserted), the programmable counter 15 is loaded with a preset value that corresponds to the worst-case number of clock cycles needed for all ADCs 11a", ..., 11c" to complete their reset sequences. As long as the counter has not reached zero, the clock-gating cell 16 holds the clock signal CLK low, preventing it from reaching the ADCs 11a", ..., 11c". Once the counter decrements to zero, it asserts the COUNTER_0 signal, which causes the clock-gating cell 16 to release CLK to all ADCs 11a", ..., 11c" simultaneously. This ensures that all ADCs 11a", ..., 11c" begin receiving clock signals at exactly the same time after their reset sequences are complete.

However, this approach has drawbacks as the ADCs 11a", ..., 11c" may contain continuous-time blocks-such as sigma-delta modulators or bias generators-that require uninterrupted clocking. Gating the clock disrupts internal bias conditions, causes charge leakage on sampling capacitors, and introduces transient effects that degrade conversion accuracy. Even with perfect gating, the channels may still fail to resume sampling in the same clock cycle because their internal state machines and digital filters might initialize in different cycles depending on their exact reset timing.

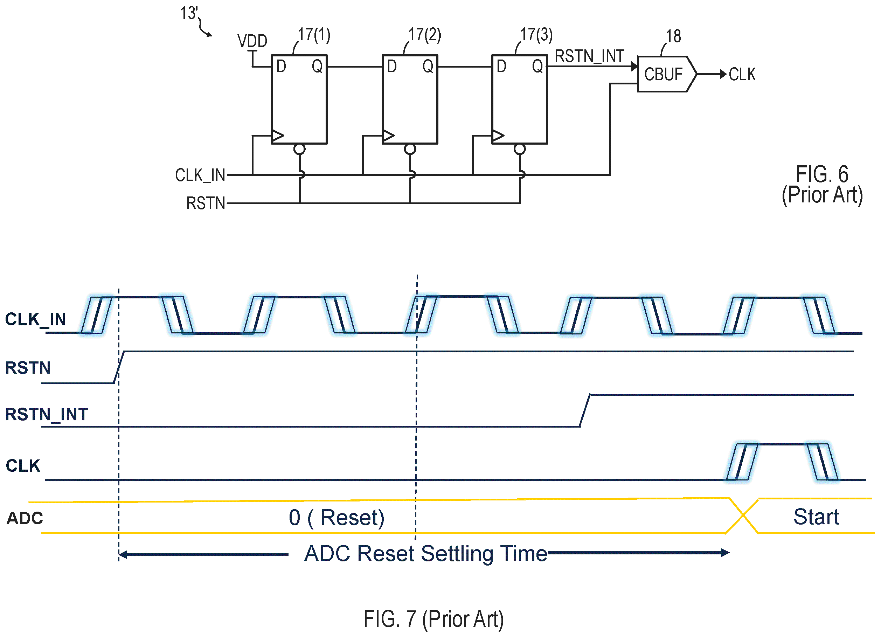

FIG. 6 shows a simplified implementation of a clock delay circuit 13', which provides a fixed delay rather than the programmable delay of clock delay circuit 13. The clock delay circuit 13' utilizes three serial D-type flip-flops 17(1), 17(2), and 17(3)-each having its asynchronous reset tied to RSTN and its D input tied to VDD-and a clock buffer 18.

FIG. 7 is a timing diagram of the clock delay circuit 13' in operation. As shown, after RSTN transitions from logic low to logic high (rising edge), RSTN_INT remains low for three rising edges of CLK_IN (the "ADC reset settling time") as counted by flip-flops 17(1), 17(2), and 17(3); during this interval, the digital output data signals from ADCs 11a", ..., 11c" are held at logic zero because the ADCs 11a", ..., 11c" remain in their reset state. This controlled delay period ensures that all internal ADC components fully stabilize after the rising edge of RSTN. Only after RSTN_INT transitions from logic low to logic high (rising edge) does buffer 18 release CLK, allowing the ADCs 11a", ..., 11c" to begin normal sampling and produce valid outputs on the next rising edge of CLK. This synchronized resumption of the CLK signal ensures that all ADCs 11a", ..., 11c" in the multi-channel system 10" begin sampling simultaneously on the same rising edge of CLK.

However, this fixed delay implementation lacks adaptability to different operating conditions. The three-cycle delay is hardcoded into the circuit topology, making it inflexible when device characteristics vary across process corners, supply voltage fluctuations, or temperature extremes. Additionally, different ADC architectures may require longer or shorter reset settling times than the fixed three cycles provided. Furthermore, like the programmable clock delay circuit 13 of FIG. 4, this fixed delay implementation still interrupts the clock signal.

Given the various approaches discussed and their respective limitations, it is evident that achieving reliable phase synchronization across multiple ADCs in high-frequency systems remains a significant engineering challenge. A robust solution is needed that can ensure ADCs exit reset simultaneously without requiring high-speed reset signal distribution or clock gating, while functioning reliably across different operating conditions and ADC architectures.

### SUMMARY

In one embodiment, a method of synchronizing a chain of devices in a multi-channel system is provided. In this method, an asynchronous reset signal is received by a first device and is synchronized to a clock domain using untimed reset removal techniques that account for potential metastability. A controlled delay is then introduced before a synchronized reset signal is generated at the output of the first device. This reset signal is conveyed to a subsequent device, where the reset signal is processed using timed reset removal to prevent further metastability, followed by another controlled delay before generating a subsequent synchronized reset signal. In some embodiments, the synchronization step includes capturing a logic high signal on the first rising edge following a low-to-high transition of the asynchronous signal and generating a trigger signal after either two or three rising clock edges-depending on whether metastability occurs-while the controlled delay in both devices comprises counting a predetermined number k of clock cycles before transitioning the reset signal from low to high.

In another embodiment, a multi-channel synchronization system is provided that comprises a chain of interconnected devices. The first device is configured with an input to receive the asynchronous reset signal, along with synchronization circuitry for untimed reset removal and delay circuitry that introduces a controlled delay before generating a synchronized output. One or more subsequent devices receive the synchronized output and process the signal using timing circuitry configured for timed reset removal, thereby preventing metastability. Each subsequent device also introduces a controlled delay, counting the same predetermined number k of clock cycles before generating a synchronized reset output. In certain implementations, the first device further includes selection circuitry that, operating in an untimed reset removal mode, chooses between the asynchronous reset and a phase-synchronized reset signal using multiplexers and flip-flop-based synchronization circuitry to generate a trigger signal based on a delay of either two or three clock cycles; the delay generation circuitry in both the first and subsequent devices then counts k cycles to ensure that internal components reach a steady state prior to outputting the reset signal.

Yet another embodiment provides a synchronization system for a multi-device chain that includes a first device and at least one subsequent device arranged in series. Here, the first device receives an asynchronous reset signal that may occur at any time relative to a clock and synchronizes the signal using flip-flop circuitry-where any potential metastability is confined to this device-before generating a trigger signal after a variable delay of either two or three clock cycles. A counter then counts a predetermined number k of clock cycles and produces a synchronized reset output. Each subsequent device receives the preceding device's synchronized reset output, introduces a deterministic delay of two clock cycles through timed reset removal, counts k clock cycles, and then generates its subsequent synchronized reset signal. In one implementation, the overall synchronization time for a chain of N devices is N(k+2) clock cycles when no metastability is encountered in the first device, or N(k+2)+1 clock cycles when metastability occurs. These and other features and advantages will be more clearly understood from the following detailed description and accompanying drawings.

### BRIEF DESCRIPTION OF THE DRAWINGS

FIG. 1 is a block diagram of a known multi-channel system including multiple ADCs, each with its own internal reset synchronizer, illustrating the challenges of achieving phase synchronization.
FIG. 2 is a block diagram showing the internal structure of a conventional reset synchronizer, which uses two D-type flip-flops to synchronize an asynchronous reset signal to the clock domain.
FIG. 3 is a block diagram of a known multi-channel system that uses a shared reset synchronizer for all ADCs, highlighting the issues of timing skew and signal distribution at high frequencies.
FIG. 4 is a block diagram of a known multi-channel system that employs a clock delay circuit to hold the clock signal until all ADCs complete their reset sequences.
FIG. 5 is a detailed block diagram of a known clock delay circuit, including a programmable counter and a clock-gating cell, used to synchronize the reset process across multiple ADCs.
FIG. 6 is a block diagram of a known simplified clock delay circuit implementation, which uses a fixed delay instead of a programmable delay to synchronize the reset process.
FIG. 7 is a timing diagram illustrating the operation of the known simplified clock delay circuit shown in FIG. 6, demonstrating the fixed three-cycle delay used to stabilize ADC components after reset.
FIG. 8 is a block diagram illustrating a multi-channel system with a cascading reset synchronization mechanism across interconnected devices, as disclosed herein.
FIG. 9 is a block diagram illustrating the reset synchronization circuitry within two interconnected devices in the multi-channel system of FIG. 8.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

### Introduction: Reset Removal Challenges

As explained above, in multi-channel systems, achieving phase synchronization across multiple devices, such as Analog-to-Digital Converters (ADCs), is a critical challenge. A primary issue arises during reset removal, where the asynchronous reset signal deassertion can coincide with the active edge of the clock signal, leading to metastability. Metastability occurs when the timing of the reset signal relative to the clock edge causes flip-flops to enter an unstable state, delaying their resolution to a valid logic level. This variability results in some ADCs recovering from reset in two clock cycles, while others take three, creating a one-cycle phase error that disrupts synchronization.

### High-Level Overview Of An All Digital Phase Synchronizer for Multi-Module Systems Disclosed Herein That Addresses These Challenges

The challenges of reset removal and phase synchronization are addressed by a propagated reset mechanism that eliminates the need for multiple reset synchronizers and instead uses sequential propagation between devices. The system includes a chain of interconnected devices, each processing and propagating a reset signal to the next device in sequence to ensure phase synchronization.

The first device in the chain receives an asynchronous reset signal which may transition at any time relative to the system clock. This device performs two functions: it first synchronizes the asynchronous reset signal to the clock domain, containing any metastability that might occur during this process, and then adds a controlled delay to allow all internal components of the device to reach a steady state before generating an output reset signal that transitions precisely coincident with a clock edge.

Each subsequent device in the chain receives a synchronized reset signal from the previous device. These devices are configured for timed reset removal, acknowledging that their input signals are already synchronized to the clock domain. This configuration difference ensures deterministic timing for all devices after the first one, eliminating the potential for metastability-induced phase errors.

The propagated reset mechanism confines any timing uncertainty to only the first device in the chain. While the first device might introduce variable delay due to potential metastability, all subsequent devices add consistent, predictable delay. This creates a total synchronization time that is both deterministic and scalable to any number of devices.

Specifics will be given hereinbelow.

### Details of All Digital Phase Synchronizer for Multi-Module Systems

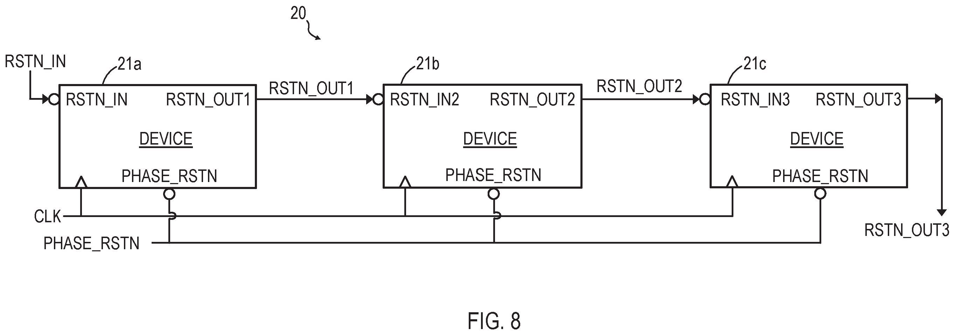

Now described with reference to FIG. 8 is a multi-channel system 20 including multiple devices 21a, 21b, 21c.

These devices may be ADCs, but may also be any type of device requiring synchronization. Each device 21a, 21b, 21c has respective first reset input RSTN_IN, RSTN_IN2, RSTN_IN3 receiving a reset signal, such as RSTN_IN for device 21a, RSTN_OUT1 for device 21b, and RSTN_OUT2 for device 21c. Each device also has a second input receiving a phase-synchronized reset signal PHASE _RSTN and a clock input receiving the clock signal CLK. RSTN_IN is received by device 21a, which generates the RSTN_OUT1 signal. Device 21b receives RSTN_OUT1 and generates the RSTN_OUT2 signal. Device 21c receives the RSTN_OUT2 signal and generates the RSTN_OUT3 signal.

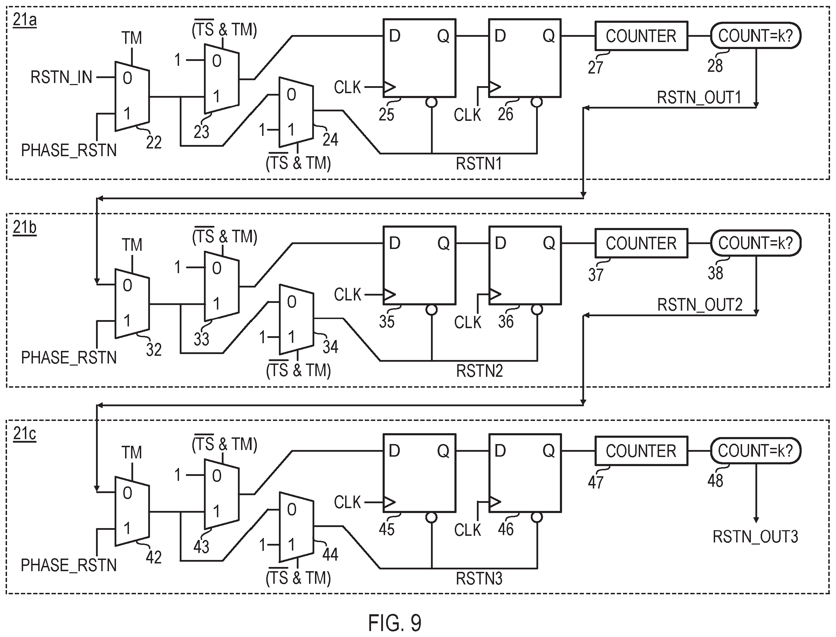

FIG. 9 shows details of the reset circuitry within devices 21a, 21b, and 21c. 21a, 21b, and 21c. First, the specific connections of the inputs and outputs of these devices 21a, 21b, and 21c will be described, and thereafter the operation of these devices will be described.

The reset circuitry within device 21a includes a first multiplexer 22 receiving the asynchronous reset signal RSTN_IN at its first input and receiving the synchronous reset signal PHASE _RSTN at its second input. A second multiplexer 24 has a first input receiving the output from the multiplexer 22 and a second input receiving a logic high signal. The multiplexer 24 generates a reset signal RSTN1 at its output. A third multiplexer 23 receives a logic high signal at its first input and receives the output of the multiplexer 22 at its second input. A first flip-flop 25 receives the output of the multiplexer 23 at its data input, is clocked by the clock signal CLK, and is reset by the RSTN1 signal. A second flip-flop 26 receives the output of the first flip-flop 25 at its data input, is clocked by the clock signal CLK, and is reset by the RSTN1 signal. A counter 27 receives the output of the flip-flop 26 as a trigger. A count check circuit 28 receives the current count of the counter 27, and generates the RSTN_OUT1 signal based upon the value of the counter 27 reaching a check value of k.

The reset circuitry within device 21b includes similar components: a first multiplexer 32 receiving the reset signal RSTN_OUT1 at its first input and receiving the synchronous reset signal PHASE _RSTN at its second input. A second multiplexer 34 has a first input receiving the output from the multiplexer 32 and a second input receiving a logic high signal. The multiplexer 34 generates a reset signal RSTN2 at its output. A third multiplexer 33 receives a logic high signal at its first input and the output of the multiplexer 32 at its second input. A first flip-flop 35 receives the output of the multiplexer 33 at its data input, is clocked by the clock signal CLK, and is reset by the RSTN2 signal. A second flip-flop 36 receives the output of the flip-flop 35 at its data input, is clocked by the clock signal CLK, and is reset by the RSTN2 signal. A counter 37 receives the output of the flip-flop 36 as a trigger. A count check circuit 38 receives the current count of the counter 37, and generates the RSTN_OUT2 signal based upon the value of the counter 37 reaching a check value of k.

The reset circuitry within device 21c follows the same pattern: a first multiplexer 42 receiving the reset signal RSTN_OUT2 at its first input and receiving the synchronous reset signal PHASE_RESETN at its second input. A second multiplexer 44 has a first input receiving the output from the multiplexer 42 and a second input receiving a logic high signal. The multiplexer 44 generates a reset signal RSTN3 at its output. A third multiplexer 43 receives a logic high signal at its first input and the output of the multiplexer 42 at its second input. A first flip-flop 45 receives the output of the multiplexer 43 at its data input, is clocked by the clock signal CLK, and is reset by the RSTN3 signal. A second flip-flop 46 receives the output of the flip-flop 45 at its data input, is clocked by the clock signal CLK, and is reset by the RSTN3 signal. A counter 47 receives the output of the flip-flop 46 as a trigger. A count check circuit 48 receives the current count of the counter 47, and generates the RSTN_OUT3 signal based upon the value of the counter 47 reaching a check value of K.

### Operation

In operation, the multi-channel system 20 achieves phase synchronization through a cascading reset mechanism that addresses the one-cycle phase error caused by metastability in reset synchronizers. Device 21a is configured for untimed reset removal by setting both the Test Mode (TM) signal and Test Select (TS) signal to 0. This configuration allows the device to properly handle the asynchronous reset signal RSTN_IN.

Specifically, RSTN_IN is an active-low reset signal, so the reset removal (deassertion) occurs when it transitions from low to high. This reset removal is what initiates the synchronization process across the chain of devices. The key challenge addressed by this design is ensuring that all devices exit reset in perfect phase alignment despite the asynchronous nature of the initial reset removal, as RSTN_IN could deassert at any moment relative to the system clock.

In device 21a, RSTN_IN connects to the first input of multiplexer 22. With TM=0, multiplexer 22 selects this RSTN_IN signal and passes it to multiplexer 24. With TM=0 and TS=0, multiplexer 24 selects this input and outputs it as RSTN1, which connects to the reset inputs of flip-flops 25 and 26. Meanwhile, multiplexer 23 (also controlled by TM&~TS=0) selects its first input, which is tied to logic high, and connects this to the data input of flip-flop 25. Multiplexer 23 selecting its first input ensures that a stable logic high signal is provided to the data input of flip-flop 25 during reset, allowing the flip-flop to properly initialize when released from reset.

When the reset removal occurs (RSTN_IN transitions from low to high), RSTN1 also transitions from low to high, releasing flip-flops 25 and 26 from their reset state. At this point, flip-flop 25 attempts to capture the logic high at its data input on the next rising edge of CLK. This is where the critical timing issue occurs - if the reset removal happens too close to a rising clock edge (violating the recovery time requirement), flip-flop 25 may enter a metastable state.

This metastability in flip-flop 25 is contained within device 21a. Under normal conditions (no metastability), flip-flop 25 would capture the logic high on the first rising edge of CLK after reset removal, and its output would become stable shortly after this rising edge. Then, flip-flop 26 would capture this stable high output on the second rising edge of CLK after reset removal. However, if metastability occurs in flip-flop 25, its output might not stabilize in time for the second rising edge of CLK. In this case, flip-flop 26 would only capture a stable high value on the third rising edge of CLK after reset removal.

Once flip-flop 26's output transitions high, this triggers counter 27 to begin counting from zero starting on the next rising edge of CLK. When counter 27 reaches value k, count check circuit 28 transitions RSTN_OUT1 from low to high synchronously with a rising edge of CLK.

The total delay from reset removal at device 21a to RSTN_OUT1 transitioning high is precisely timed by the counter value K. Specifically, K equals Max _count-2, where Max_count represents the total counter value needed for an ADC to fully stabilize after reset. This counter value is designed to allow sufficient time after the reset synchronization for all internal ADC components to settle before triggering the next device. The complete delay is therefore K+2 rising clock edges (if no metastability occurred) or K+3 rising clock edges (if metastability delayed the propagation).

As shown in FIG. 9, the RSTN_OUT1 signal from device 21a is connected to the first input of multiplexer 32 within device 21b. Device 21b is configured with TM=0 and TS=1 for "timed reset removal," while device 21a has TM=0 and TS=0 for "untimed reset removal."

With TM=0 in both devices 21a and 21b, the boolean control signal TM&~TS equals 0 in both cases:
In device 21a: TM=0, TS=0, so TM&~TS = 0&~0 = 0&1 = 0
In device 21b: TM=0, TS=1, so TM&~TS = 0&~1 = 0&0 = 0

This means that in both devices, the multiplexers make the same selections: multiplexer 34 in device 21b selects its first input (from multiplexer 32) and outputs this as RSTN2, while multiplexer 33 selects its first input (logic high) and connects this to the data input of flip-flop 35.

The difference between the devices 21a and 21b is in the nature of their input signals. Device 21b receives RSTN_OUT1, which is already synchronized to the clock domain (having been generated by count check circuit 28 in device 21a in response to a rising edge of CLK). Recall that RSTN_OUT1 transitions from low to high when counter 27 in device 21a reaches the value K, which occurs K clock cycles after flip-flop 26's output transitions high. When RSTN_OUT1 transitions from low to high, this transition propagates through multiplexers 32 and 34 to become RSTN2, which then releases flip-flops 35 and 36 from their reset state.

Because RSTN_OUT1 transitions synchronously with the clock, flip-flop 35 cleanly captures the logic high on the first rising edge of CLK after RSTN2 transitions to logic high, and flip-flop 36 captures the high output from flip-flop 35 on the second rising edge of CLK after RSTN2 transitions to logic high. This creates a precisely timed two-rising-edge delay with no possibility of metastability.

The high output from flip-flop 36 triggers counter 37 to begin counting on the next rising edge of CLK. After k rising clock edges, count check circuit 38 causes RSTN_OUT2 to transition from low to high coincident with a rising edge of CLK.

As shown in FIG. 9, RSTN_OUT2 from device 21b is connected to the first input of multiplexer 42 in device 21c. Device 21c is also configured with TM=0 and TS=1 for "timed reset removal," just like device 21b. The same multiplexer selections and signal paths occur in device 21c as in device 21b, with the synchronized RSTN_OUT2 signal propagating through to become RSTN3, which releases flip-flops 45 and 46 from their reset state.

With timed reset removal, device 21c also experiences a precisely timed two-rising-edge delay through its flip-flops, followed by k rising clock edges of counting through counter 47 before count check circuit 48 transitions RSTN_OUT3 from low to high.

Each subsequent device adds exactly K+2 rising clock edges of deterministic delay, with no possibility of metastability-induced variability after the first device. In the example shown, there are three devices 21a, 21b, and 21c, but there may be any number N of such devices. The total synchronization time for N devices is therefore either N(K+2) or N(K+2)+1 rising clock edges, with the +1 occurring only if metastability occurred in device 21a.

For testing purposes, setting TM=1 activates test mode, where all devices select PHASE _RSTN instead of their cascaded inputs, allowing simultaneous reset of all devices.

### Advantages

The disclosed system offers several key advantages that address the challenges of reset removal and phase synchronization in multi-channel systems. By using a sequential propagation mechanism, the system avoids the metastability issues associated with multiple reset synchronizers, in turn ensuring that all devices achieve phase synchronization after a predictable number of clock cycles, eliminating timing uncertainties. Also, due to the sequential propagation mechanism, adjacent devices are connected with very short routing distances, allowing reliable signal transmission between them without the need for high-speed routing across the entire system.

In addition, the system is inherently robust against external disruptions, as any temporarily desynchronized device will automatically realign with the chain. Finally, the design of the system is highly scalable and can be extended to dozens or hundreds of devices while maintaining phase synchronization across the entire system. Furthermore, the modular nature of the design makes it suitable for a wide range of applications, including digital or mixed-signal components such as physical layer interfaces, serializer/deserializer blocks, digital signal processors (DSPs), and computational blocks. This versatility ensures that the system disclosed herein can address synchronization challenges in a variety of high-speed, multi-module environments.

### Conclusion

Although this disclosure has been described with a limited number of embodiments, those skilled in the art, having the benefit of this disclosure, can envision other embodiments that do not deviate from the disclosed scope; it is evident that modifications and variations can be made to what has been described and illustrated herein without departing from the scope of this disclosure. For example, while ADCs are used as examples hereinabove, the devices requiring synchronization could be any digital or mixed-signal components, including physical layer interfaces, serializer/deserializer blocks, digital signal processors (DSPs), field-programmable gate arrays, or other computation blocks operating in parallel. For instance, in high-speed communication systems, multiple PHY lanes must operate in precise synchronization to maintain data integrity across parallel channels. Indeed, the modular nature of the design makes it suitable for a wide range of multi-module systems.

## Claims

1. A method of synchronizing a chain of devices (21a, 21b, 21c) in a multi-channel system (20), the method comprising:
receiving an asynchronous reset signal (RSTN_IN) at a first device (21a) in the chain of devices;
synchronizing the asynchronous reset signal to a clock domain in the first device using untimed reset removal, wherein the synchronizing includes handling potential metastability in the first device;
after synchronizing, introducing a controlled delay in the first device;
generating a synchronized reset signal (RSTN _OUT1) at an output of the first device after the controlled delay;
receiving the synchronized reset signal at an input of a subsequent device (21b) in the chain;
processing the synchronized reset signal in the subsequent device using timed reset removal, which prevents metastability;
introducing a controlled delay in the subsequent device; and
generating a subsequent synchronized reset signal (RSTN_OUT2) at an output of the subsequent device.

2. The method of claim 1, wherein synchronizing the asynchronous reset signal (RSTN_IN) in the first device (21a) comprises:
capturing a logic high data signal upon a first rising edge of a system clock (CLK) after the asynchronous reset signal (RSTN _IN) transitions from a logic low to a logic high; and
generating a synchronized trigger signal after either two or three rising edges of the system clock, depending on whether metastability occurs during the capturing.

3. The method of claim 2, wherein introducing the controlled delay in the first device (21a) comprises:
initiating a counting sequence upon receiving the synchronized trigger signal;
counting a predetermined number of system clock cycles defined by a value k; and
transitioning the synchronized reset signal (RSTN_OUT) from a logic low to a logic high coincident with a rising edge of the system clock (CLK) when the count reaches the value k.

4. The method of claim 3, wherein processing the synchronized reset signal (RSTN_OUT1) in the subsequent device (21b) comprises:
capturing a logic high data signal upon a first rising edge of the system clock (CLK) after the synchronized reset signal (RSTN _OUT1) transitions from a logic low to a logic high; and
generating a synchronized trigger signal after exactly two rising edges of the system clock.

5. The method of claim 4, wherein introducing the controlled delay in the subsequent device (21b) comprises:
initiating a counting sequence upon receiving the synchronized trigger signal from the subsequent device;
counting the predetermined number of system clock cycles defined by the value k; and
transitioning the subsequent synchronized reset signal (RSTN_OUT2) from a logic low to a logic high coincident with a rising edge of the system clock (CLK) when the count reaches the value k.

6. A multi-channel synchronization system (20), comprising:
a plurality of devices (21a, 21b, 21c) connected in a chain, comprising:
a first device (21a) in the chain comprising:
an input configured to receive an asynchronous reset signal (RSTN_IN);
reset synchronization circuitry (25, 26) configured to synchronize the asynchronous reset signal to a clock domain;
delay circuitry (27, 28) configured to introduce a controlled delay after synchronization; and
an output at which a synchronized reset signal (RSTN _OUT1) is generated after the controlled delay; and
at least one subsequent device (21b, 21c), each comprising:
an input configured to receive the synchronized reset signal (RSTN_OUT1, RSTN_OUT2);
timing circuitry (35, 36, 37, 38; 45, 46, 47, 48) configured to process the synchronized reset signal with the controlled delay; and
an output at which the synchronized reset signal (RSTN_OUT2, RSTN_OUT3) is generated after the controlled delay;
wherein the first device is configured for untimed reset removal and each subsequent device (21b, 21c) is configured for timed reset removal.

7. The multi-channel synchronization system (20) of claim 6, wherein the first device (21a) further comprises:
selection circuitry (22, 23, 24) configured to, when the first device is in an untimed reset removal mode:
pass the asynchronous reset signal (RSTN_IN) to thereby generate a device reset signal (RSTN1); and
pass a logic high data signal when the first device is not in reset;
synchronization circuitry (25, 26) responsive to the device reset signal (RSTN1) and configured to:
capture the logic high data signal upon a first rising edge of a system clock (CLK) after the device reset signal transitions from a logic low to logic high; and
generate a synchronized trigger signal after either two or three rising edges of the system clock depending on whether metastability occurs during the capturing of the logic high data signal; and
delay generation circuitry (27, 28) responsive to the synchronized trigger signal and configured to:
initiate a counting sequence upon receiving the synchronized trigger signal and then counting a predetermined number of system clock cycles defined by a value k; and
generate an output reset signal (RSTN_OUT1) that transitions from logic low to logic high coincident with a rising edge of the system clock when the count reaches value k, wherein the value k is selected to allow internal components of the first device to reach a steady state, wherein the output reset signal is the synchronized reset signal generated at the output of the first device.

8. The multi-channel synchronization system (20) of claim 7,
wherein the selection circuitry (22, 23, 24) comprises:
a first multiplexer (22) having a first input configured to receive the asynchronous reset signal (RSTN _IN), a second input configured to receive a phase-synchronized reset signal (PHASE _RSTN), a control input configured to receive a test mode signal (TM), and an output;
a second multiplexer (24) having a first input coupled to the output of the first multiplexer (22), a second input coupled to a logic high signal, a control input coupled to a logical combination of the test mode signal (TM) and an inverse of a test select signal (TS), and an output providing the device reset signal (RSTN1); and
a third multiplexer (23) having a first input coupled to a logic high signal, a second input coupled to the output of the first multiplexer (22), a control input coupled to the logical combination of the test mode signal (TM) and the inverse of the test select signal (TS), and an output providing the logic high data signal;
wherein the test mode signal (TM) and the test select signal (TS) are a logic low when the first device (21a) is in the untimed reset removal mode;
wherein the synchronization circuitry (25, 26) comprises:
a first flip-flop (25) having a data input coupled to the output of the third multiplexer, a clock input coupled to the system clock (CLK), a reset input coupled to the output of the second multiplexer (24), and an output; and
a second flip-flop (26) having a data input coupled to the output of the first flip-flop (25), a clock input coupled to the system clock (CLK), a reset input coupled to the output of the second multiplexer (24), and an output providing the synchronized trigger signal; and
wherein the delay generation circuitry (27, 28) comprises:
a counter (27) having a trigger input coupled to the output of the second flip-flop (26), a clock input coupled to the system clock, and a count output; and
a count check circuit (28) having an input coupled to the count output of the counter (27) and an output coupled to the output of the first device, wherein the count check circuit is configured to transition its output from logic low to logic high when the count output reaches the value k.

9. The multi-channel synchronization system (20) of claim 7 or 8, wherein each subsequent device (21b, 21c) further comprises:
selection circuitry (32, 33, 34; 42, 43, 44) configured to, when the subsequent device is in timed reset removal mode:
pass the synchronized reset signal (RSTN_OUT1, RSTN_OUT2) to thereby generate a device reset signal (RSTN2, RSTN3); and
pass a logic high data signal when the subsequent device is not in reset;
synchronization circuitry (35, 36; 45, 46) responsive to the device reset signal and configured to:
capture the logic high data signal upon a first rising edge of a system clock (CLK) after the device reset signal transitions from a logic low to logic high; and
generate a synchronized trigger signal after exactly two rising edges of the system clock, with no possibility of metastability-induced delay due to the synchronized reset signal (RSTN_OUT1, RSTN _OUT2) being already aligned with the system clock domain; and
delay generation circuitry (37, 38; 47, 48) responsive to the synchronized trigger signal and configured to:
initiate a counting sequence upon receiving the synchronized trigger signal and then counting a predetermined number of system clock cycles defined by a value k; and
generate a subsequent synchronized reset signal (RSTN_OUT2, RSTN_OUT3) that transitions from logic low to logic high coincident with a rising edge of the system clock when the count reaches the value k.

10. The multi-channel synchronization system (20) of claim 9, wherein:
the selection circuitry (32, 33, 34; 42, 43, 44) of each subsequent device (21b, 21c) comprises:
a first multiplexer (32, 42) having a first input configured to receive the synchronized reset signal (RSTN_OUT1, RSTN _OUT2), a second input configured to receive a phase-synchronized reset signal (PHASE_RSTN), a control input configured to receive a test mode signal (TM), and an output;
a second multiplexer (34, 44) having a first input coupled to the output of the first multiplexer, a second input coupled to a logic high signal, a control input coupled to a logical combination of the test mode signal and an inverse of a test select signal (TS), and an output providing the device reset signal; and
a third multiplexer (33, 43) having a first input coupled to a logic high signal, a second input coupled to the output of the first multiplexer (32, 42), a control input coupled to the logical combination of the test mode signal and the inverse of the test select signal, and an output providing the logic high data signal;
wherein the test mode signal is a logic low and the test select signal is a logic high when the subsequent device is in the timed reset removal mode;
the synchronization circuitry (35, 36; 45, 46) of each subsequent device comprises:
a first flip-flop (35, 45) having a data input coupled to the output of the third multiplexer, a clock input coupled to the system clock, a reset input coupled to the output of the second multiplexer, and an output; and
a second flip-flop (36, 46) having a data input coupled to the output of the first flip-flop, a clock input coupled to the system clock, a reset input coupled to the output of the second multiplexer, and an output providing the synchronized trigger signal; and
the delay generation circuitry (37, 38; 47, 48) of each subsequent device comprises:
a counter (37, 47) having a trigger input coupled to the output of the second flip-flop, a clock input coupled to the system clock, and a count output; and
a count check circuit (38, 48) having an input coupled to the count output of the counter and an output coupled to the output of the subsequent device, wherein the count check circuit is configured to transition its output from logic low to logic high when the count output reaches the value k.

11. The multi-channel synchronization system (20) of claim 6, wherein:
the asynchronous reset signal (RSTN_IN) may transition at any time relative to a clock (CLK) of the clock domain;
the reset synchronization circuitry (25, 26) of the first device (21a) is configured to synchronize the asynchronous reset signal to the clock using flip-flop circuitry (25, 26), wherein metastability may occur in the flip-flop circuitry if the transition of the asynchronous reset signal (RSTN _IN) coincides with an edge of the clock; and to generate a trigger signal after a variable delay of either two or three clock cycles depending on whether the metastability occurs;
the delay circuitry (27, 28) of the first device (21a) is configured to count a predetermined number k of clock cycles after receiving the trigger signal; and generate the synchronized reset output (RSTN _OUT1) that transitions coincident with an edge of the clock after the count completes;
wherein the at least one subsequent device (21b, 21c) is configured to receive, as a reset input, the synchronized reset output (RSTN _OUT1, RSTN _OUT2) from a preceding device in the multi-device chain;
the timing circuitry (35, 36, 37, 38; 45, 46, 47, 48) of the at least one subsequent device (21b, 21c) comprises flip-flop circuitry (35, 36; 45, 46) that operates deterministically with exactly two clock cycles of delay due to the synchronized reset output received as the reset input being already synchronized to the clock; and is configured to:
generate a trigger signal after the two clock cycles of delay;
count the predetermined number k of cycles of the clock after receiving the trigger signal of the at least one subsequent device; and
generate, as a reset output, a subsequent synchronized reset output (RSTN_OUT2, RSTN _OUT3) that transitions coincident with an edge of the clock after the count completes;
wherein metastability is confined to the first device, and each subsequent device operates with deterministic k+2 clock cycle delay between receiving its reset input and generating its reset output.

12. The multi-channel synchronization system (20) of claim 11, wherein the flip-flop circuitry (25, 26) in the first device comprises:
a first flip-flop (25) configured to capture a logic high signal upon a first rising edge of the clock (CLK) after the asynchronous reset signal (RSTN_IN) transitions from logic low to logic high; and
a second flip-flop (26) configured to capture an output of the first flip-flop, wherein the trigger signal is generated from an output of the second flip-flop.

13. The multi-channel synchronization system (20) of claim 11 or 12,
wherein the first device (21a) comprises:
a counter (27) configured to initiate counting upon receiving the trigger signal of the first device and to count the predetermined number k of clock cycles; and
a count check circuit (28) configured to transition the synchronized reset output (RSTN_OUT1) from logic low to logic high when the counter reaches the value k; and
wherein each subsequent device (21b, 21c) comprises:
a counter (37, 47) configured to initiate counting upon receiving the trigger signal of that subsequent device and to count the predetermined number k of clock cycles; and
a count check circuit (38, 48) configured to transition the subsequent synchronized reset output (RSTN _OUT2, RSTN _OUT3) from logic low to logic high when the counter reaches the value k.

14. The multi-channel synchronization system (20) of any one of claims 11 to 13, wherein the predetermined number k is selected to allow internal components of the first device and each subsequent device to reach a steady state after reset.

15. The multi-channel synchronization system (20) of any one of claims 11 to 14, wherein a total synchronization time for N devices in the multi-device chain is N(k+2) if metastability does not occur in the first device, but is N(k+2)+1 clock cycles if metastability occurs in the first device.
